# EUROPEAN PATENT APPLICATION

(11) **EP 2 211 295 A2**
(43) Date of publication of application: **28.07.2010**
(21) Application number: 10000633.7
(22) Date of filing: 22.01.2010
(51) Int. Cl.: G06K 19/077, H05K 1/00

(54) **Signal processing device applicable to a Subscriber Identity Module (SIM)**

(30) Priority: 23.01.2009 TW 98201478 U; 23.01.2009 TW 98201479 U
(71) Applicant: Phytrex Technology Corporation, Xinyi Dist T'ai pei (TW)
(72) Inventor: Hsiao, Feng-Chi, Taipei (TW); Yang, Kun-Shan, Taipei (TW); Lin, Tung-Fu, Taipei (TW); Cheng, Chin-Fen, Taipei (TW); Lee, Chih-Wei, Taipei (TW)
(74) Representative: UEXKÜLL & STOLBERG

(57) **Abstract**

The present invention provides a signal processing device comprising: a first substrate (11), one side surface thereof (20) being provided with at least a first contact and a second contact while the other side surface thereof being provided with at least a third contact and a fourth contact, there being an electrical connection between the first and third contacts; a second substrate (10), one side surface thereof being provided with at least an integrated circuit (102) or an antenna (13); and a first connecting portion (12) for connecting the first and second substrates; wherein the second and fourth contacts are electrically connected to the integrated circuit or antenna via the first connecting portion.

## Description

### BACKGROUND

### FIELD OF THE INVENTION

The present invention relates to a signal processing device applicable to the Subscriber Identify Module (SIM), and more particularly, to the technical field regarding the integration of dual cards and NFC antenna coils.

### DESCRIPTION OF THE PRIOR ART

With the internationalization of corporations, efficiency is the key to competing successfully in the global market, thus the mobile phone has become the most important gadget for businessmen/women. For one who is about to embark on a short-term business trip, s/he needs to get a phone number from a local telecommunication service provider so as to save international roaming fees. In the past, a businessman/woman either carried two mobile phones or swapped SIM cards repetitively while on a business trip abroad, and that was not only inconvenient but also inefficient. Today, both mobile network operators and telecommunication service providers provide services regarding dual SIM mobile phones so as to facilitate reducing international mobile phone fees. Currently, a SIM card is used in a mobile phone to store the user's phone number, phone book and system information, such as the Personal Identification Number (PIN) code and user ID, and to perform antitheft function, access control function, etc. However, people's heavy reliance on mobile phones gives rise to the needs to integrate the near field communication (NFC) functions, such as the functions of EasyCard, credit card and entrance card, into a SIM card, and this means the SIM card requires a greater capacity. The SIM Application Toolkit (STK) is a standard of the Global System for Mobile Communications (GSM), which defines the interface between a SIM card and a mobile phone as well as the operating procedure. Specifically, the STK is a standard interface tool for developing application service on a SIM card that enables applications in the SIM card to be operated by any mobile phone.

Among the developed technologies is a technology that employs the flexible printed circuit (FPC) technology to fabricate a very thin smart card. Accordingly, the smart card can be seamlessly attached to the SIM card provided by another telecommunication service provider and then be inserted into the mobile phone along with the SIM card. The smart card comprises an IC chip loaded with software that enhances a SIM card's functionality, facilitates the integration of relevant value-added services and enables the user to shift between different phone numbers by means of the STK. The IC chip is attached to the flexible printed circuit board by means of the flip-chip technology. However, the flip-chip technology involves forming an opening on the SIM card to which the smart card is to be attached, and the opening should conform to the size of the IC chip so that the IC chip can be snapped therein seamlessly. The requirement of an opening means the SIM card to which the smart card is to be attached must undergo a destructive procedure, and this may provoke disputes between the user and the telecommunication service provider later on, causing much inconvenience to the user.

Additionally, the hardware architecture of the SIM card meets ISO 7816 international standards which specify eight contacts (C1. Vcc, C2. RST, C3. CLK, C4. RFU, C5. GND, C6. Vpp, C7. I/O, C8. RFU). As a number of technologies regarding the integration of the NFC function into a SIM card have been developed, a mobile phone can wirelessly communicate with other nearby electronic devices via an NFC antenna, which is formed by coils to conform to the hardware architecture of the mobile phone. The NFC antenna is of certain dimensions and extends through the connecting portion to connect to the contacts on the SIM card. The connecting portion is fabricated using the FPC technology so that it will deform when the SIM card is inserted into the slot, thereby reducing the space required by the antenna.

Though the flexible printed circuit is bendable, the angle to which the circuit can be bent is limited. When the flexible printed circuit is bent to the extent that a so-called "dead fold" is formed, it will be damaged, making the wiring thereof unable to perform the transmission function. When the SIM card integrated with the antenna is inserted into the narrow internal space of the mobile phone, the incautious arrangement thereof will cause a dead fold to be formed on the connecting portion, resulting in irreparable damage.

### SUMMARY

An object of the present invention is to provide a signal processing device whose mating configuration permits dual cards to be used in a single mobile phone or enables information processing functions to be added to a SIM card without changing the structure of the SIM card.

Another object of the present invention is to provide a signal processing device equipped with an antenna and capable of resolving the problem that a dead fold may be formed on the bent portion and damage the wiring when the NFC antenna is placed in the battery compartment of a mobile phone. To achieve the aforementioned objects, the present invention provides a signal processing device comprising: a first substrate, one side surface thereof being provided with at least a first contact and a second contact while the other side surface thereof being provided with at least a third contact and a fourth contact, there being an electrical connection between the first and third contacts; a second substrate, one side surface thereof being provided with at least an IC or an antenna coil; and a first connecting portion for connecting the first and second substrates; wherein the second and fourth contacts are electrically connected to the IC or antenna coil via the first connecting portion.

The aforementioned signal processing device further comprises: a third substrate whose one side surface is provided with at least a fifth contact and a sixth contact and whose the other side surface is provided with at least a seventh contact and a eighth contact; and a second connecting portion for connecting the third and second substrates; wherein there is an electrical connection between the fifth and seventh contacts; and wherein the sixth and eighth contacts are electrically connected to the IC via the second connecting portion.

The aforementioned IC converts signals, including data signals, between the second and fourth contacts.

The aforementioned IC converts signals, including data signals, between the sixth and eighth contacts.

The aforementioned first and second contacts are configured to electrically connect to a SIM card while the aforementioned third and fourth contacts are configured to electrically connect to a portable communication device.

Two copper posts are mounted proximate to the aforementioned IC and configured to electrically connect to an NFC antenna.

One side surface of the aforementioned first connecting portion is attached with a buffering pad to prevent a dead fold from forming on the first connecting portion.

The buffering pas is fabricated from a PORON material or selected from the group of products comprising SRS-40P, SRS-48P and SRS-70P.

In order to achieve the aforementioned objects, the present invention provides a signal processing device comprising: a first substrate, one side surface thereof being provided with a first contact and a second contact; a second substrate provided with an antenna coil; and a first connecting portion for connecting the first and second substrates; wherein the first and second contacts are electrically connected to the antenna coil via the first connecting portion; and wherein one side surface of the first connecting portion is provided with a buffering pad to prevent a dead fold from forming on the bent portion.

### BRIEF DESCRIPTION OF THE DRAWINGS

Fig. 1 is a frontal view of one embodiment of the present invention.
Fig. 2 is a rear view of the embodiment shown in Fig. 1.
Fig. 3 is a side view of the embodiment shown in Fig. 1.
Fig. 4 is a side view showing the embodiment shown in Fig. 1 and a SIM card.
Fig. 5A is a frontal view of another embodiment of the present invention.
Fig. 5B is a rear view of the embodiment shown in Fig. 5A.
Fig. 6 is a top view of the present signal processing device.
Fig. 7 is a side view of the present signal processing device.
Fig. 8 is a side view showing the combination of the present signal processing device integrated with the SIM card and the mobile phone battery.
Fig. 9 is a side view showing another way of combination of the present signal processing device integrated with the SIM card and the mobile phone battery.
Fig. 10 is a side view showing another way of combination of the present signal processing device integrated with the SIM card and the mobile phone battery.

### DETAILED DESCRIPTION OF THE PREFERRED EMBODIMENTS

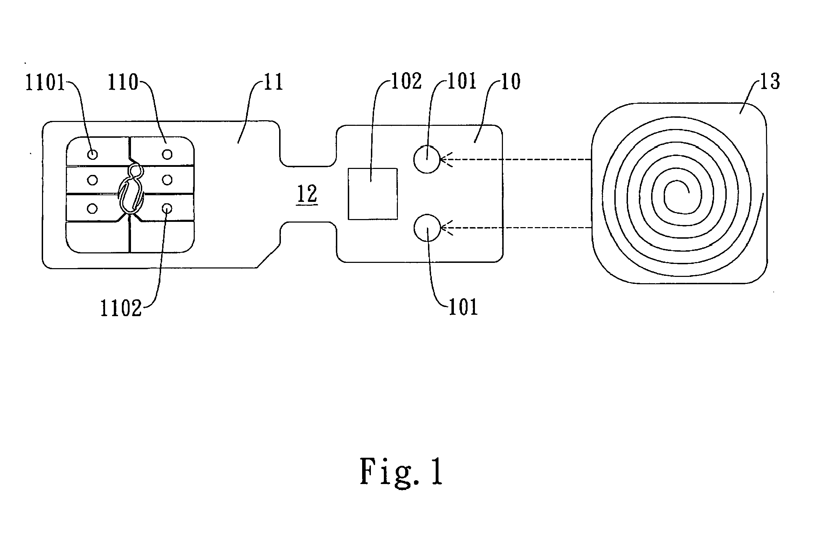

Fig. 1 is a frontal view of one embodiment of the present invention. As shown in Fig. 1, the present signal processing device for converting at least a portion of the signals between a SIM/USIM card and a mobile phone comprises a first substrate 11, a second substrate 10 and a first connecting portion 12 for connecting the first and second substrates 11 and 10. The first substrate 11, the second substrate 10 and the first connecting portion 12 are all fabricated using the FPC technology. One side surface of the first substrate 11 is provided with a contact region 110 comprising at least a third contact and a fourth contact which are configured to electrically connect to a portable communication device (e.g. a mobile phone). In this embodiment, the contact region 110 comprises eight contacts (C1. Vcc, C2. RST, C3. CLK, C4. RFU, C5. GND, C6. Vpp, C7. I/O, C8. RFU) that meet ISO 7816 international standards, wherein C1. Vcc and C5. GND may be regarded as the third contact while C7. I/O may be regarded as the fourth contact.

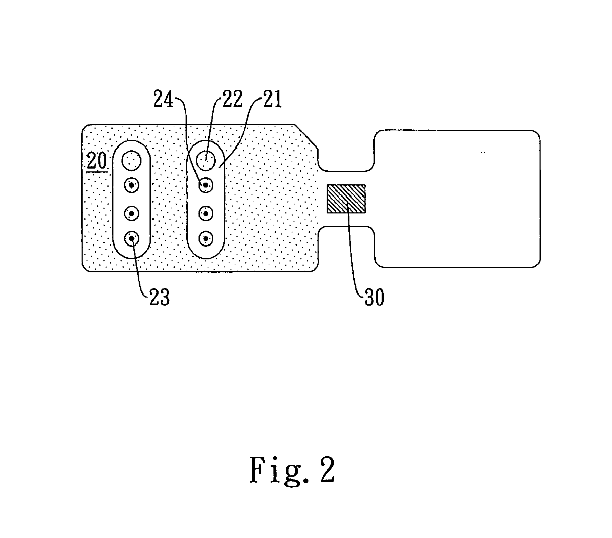

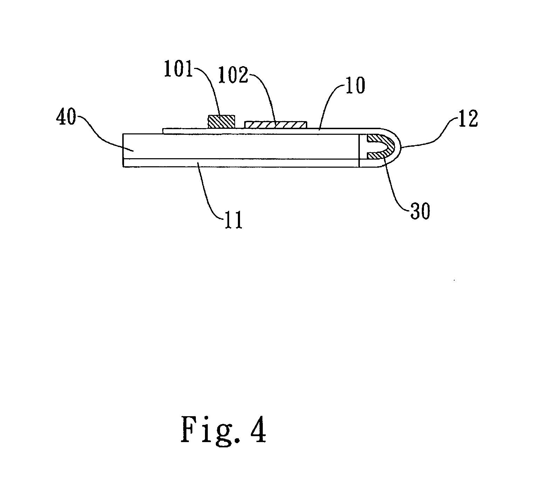

Fig. 2 is a rear view of the embodiment shown in Fig. 1. The other side surface (i.e. the rear side surface) of the first substrate 11 is provided with a contact region 21 comprising at least a first contact and a second contact which are configured to electrically connect to a SIM card 40 (see Fig. 4), wherein there is an electrical connection between the first and third contacts. Additionally, certain area of the rear side surface is coated with an adhesive material so that the rear side surface can be adhered to the SIM card 40. In one embodiment of the present invention, the contacts of the contact region 21 also meet ISO 7816 international standards, and the locations thereof correspond to the locations of the contacts of the contact region 110, wherein C1. Vcc and C5. GND may be regarded as the first contact while C7. I/O may be regarded as the second contact.

In the present signal processing device, one side surface of the second substrate 10 is provided with at least an IC 102. The second and fourth contacts are electrically connected to the IC 102 via the first connecting portion 12 and the signals (e.g. data signals) therebetween are converted by the IC 102.

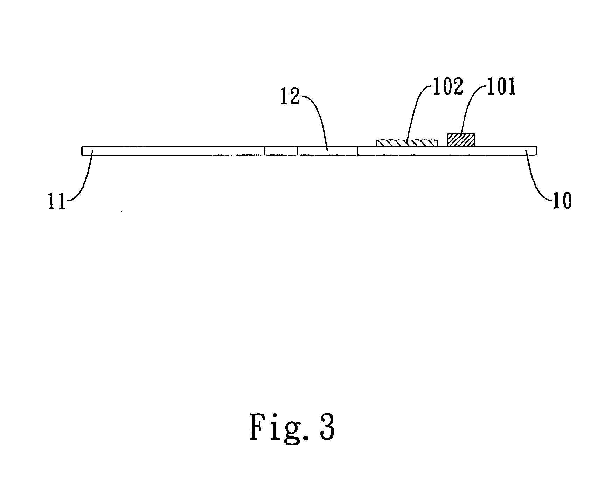

Fig. 3 is a side view of the embodiment shown in Fig. 1. The side surface of the second substrate 10 on which the IC 102 is disposed is provided with at least one protruding post whose height is at least greater than that of the IC 102. In one embodiment of the present invention, when the signal processing device integrated with the SIM card 40 is installed in a portable communication device (e.g. a mobile phone) whose narrow internal space also accommodates the battery, the higher protruding post creates some space above the IC 102 to protect it from being crushed. In another embodiment of the present invention, the first connecting portion 12 may have a length of approximately 6-18 mm so that it can be adjusted to conform to portable communication devices of different interior layout.

In one embodiment of the present invention, the protruding post may be a copper post. Preferably, two copper posts 101 are mounted proximate to the IC 102. In another embodiment of the present invention, the copper posts 101 are electrically connected to and provide protection for the IC 102. Additionally, the copper posts 101 may be electrically connected to an antenna 13 to provide other value added services, such as the integration of the function of an EasyCard or an entrance card.

In another embodiment of the present invention, the copper posts 101 may be electrically connected to the second or fourth contact and the antenna 13. In another embodiment of the present invention, the copper posts 101 may also be electrically connected to the first or third contact and the antenna 13. In yet another embodiment of the present invention, as shown in Fig. 2, one side surface of the first substrate 11 may be provided with at least a ninth contact which corresponds to the contact 22 and is electrically connected to neither the IC 102 nor the contacts of the rear side surface. One of the copper posts 101 is electrically connected to the ninth contact and the antenna 13.

Fig. 4 is a side view showing the embodiment shown in Fig. 1 and a SIM card. The adhering region 20 shown in Fig. 2 is coated with an adhesive material so that it can be adhered to the SIM card 40 (see Fig. 4). Moreover, one side surface of the first connecting portion 12 (see Fig. 2) is attached with a first buffering pad 30 to prevent a dead fold from forming on the first connecting portion 12 (see Fig. 4). In one embodiment of the present invention, the first buffering pad 30 is fabricated from a PORON material. In one preferred embodiment of the present invention, the first buffering pad 30 has a thickness of 0.4 mm.

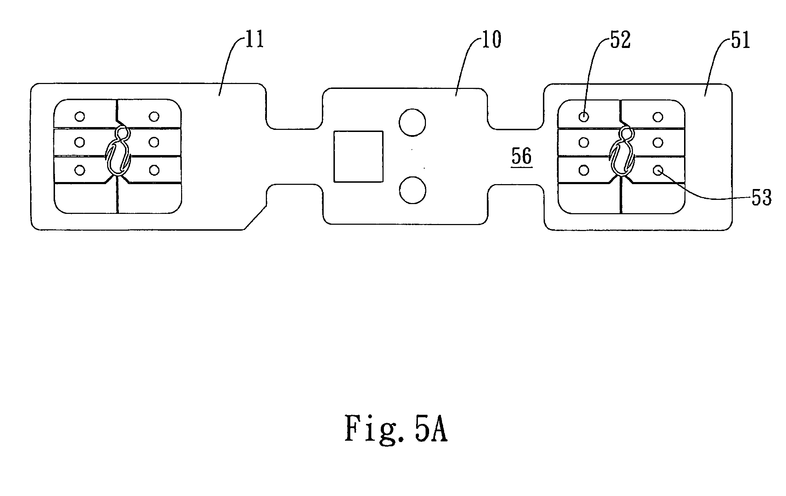

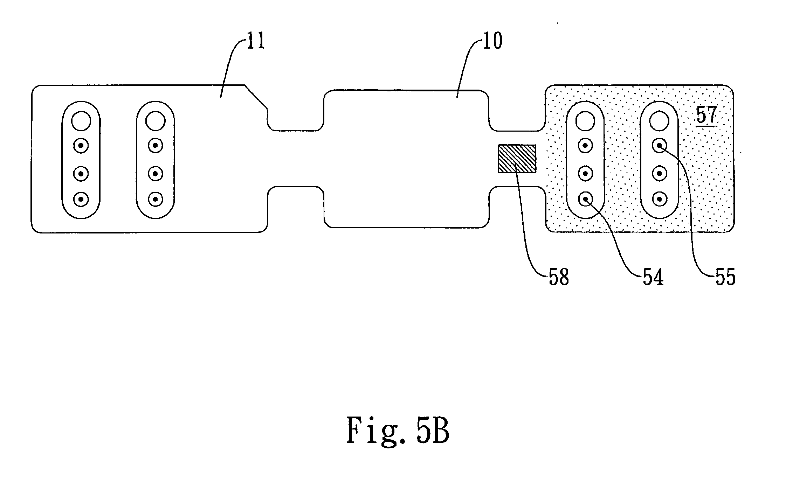

Fig. 5A is a frontal view of another embodiment of the present invention. The present signal processing device may further comprise a third substrate 51 and a second connecting portion 56 for connecting the third and second substrates 51 and 10. The third substrate 51 and the second connecting portion 56 are both fabricated using the FPC technology. One side surface of the third substrate 51 is provided with at least a seventh contact and a eighth contact which are configured to electrically connect to a portable communication device (e.g. a mobile pone). Fig. 5B is a rear view of the embodiment shown in Fig. 5A. The other side surface of the third substrate 51 is provided with at least a fifth contact and a sixth contact which are configured to electrically connect to a SIM card, wherein there is an electrical connection between the fifth and seventh contacts, and wherein the sixth and eighth contacts are electrically connected to the IC 102 via the second connecting portion 56 and the signals (e.g. data signals) therebetween are converted by the IC 102.

In one preferred embodiment of the present invention, as shown in Figs. 5A and 5B, the seventh contact includes the contact 52 and the fifth contact includes the contact 54, and the contacts 52 and 54 correspond to C1. Vcc among the eight contacts which meet ISO 7816 international standards. In another embodiment of the present invention, the fifth and seventh contacts electrically connect to electrical grounding, and the fifth and seventh contacts correspond to C5. GND among the eight contacts which meet ISO 7816 international standards. In another embodiment of the present invention, the eighth contact includes the contact 53 and the sixth contact includes the contact 55, and the contacts 53 and 55 correspond to C7. I/O among the eight contacts which meet ISO 7816 international standards. Referring to Fig. 5B, the adhering region 57 of the third substrate 51 is coated with an adhesive material so that it can be adhered to the SIM card. In addition, one side surface of the second connecting portion 56 (see Fig. 5B) is attached with a second buffering pad 58 to prevent a dead fold from forming on the second connecting portion 56. In one embodiment of the present invention, the second buffering pad 58 is fabricated from a PORON material. In one preferred embodiment of the present invention, the second buffering pad 58 has a thickness of 0.4 mm.

The present signal processing device can be attached to the SIM card by means of adhesive material without changing the hardware architecture of the SIM card. Moreover, the present signal processing device may also comprise a third substrate 51 in addition to the first substrate 11 so that the user can select an appropriate design form according to the hardware architecture of his/her mobile phone. Such design is user friendly and of great convenience in use. In addition, the present signal processing device is not limited to be used in SIM cards, but can be used in USIM cards.

When the IC 102 illustrated in Fig. 1 is applied to a SIM card or an USIM card, the second substrate 10 may be directly provided with an antenna coil. The two ends of the antenna coil are electrically connected to the two contacts of the first substrate 11 so that the IC of the SIM card or USIM card can be electrically connected to the antenna coil.

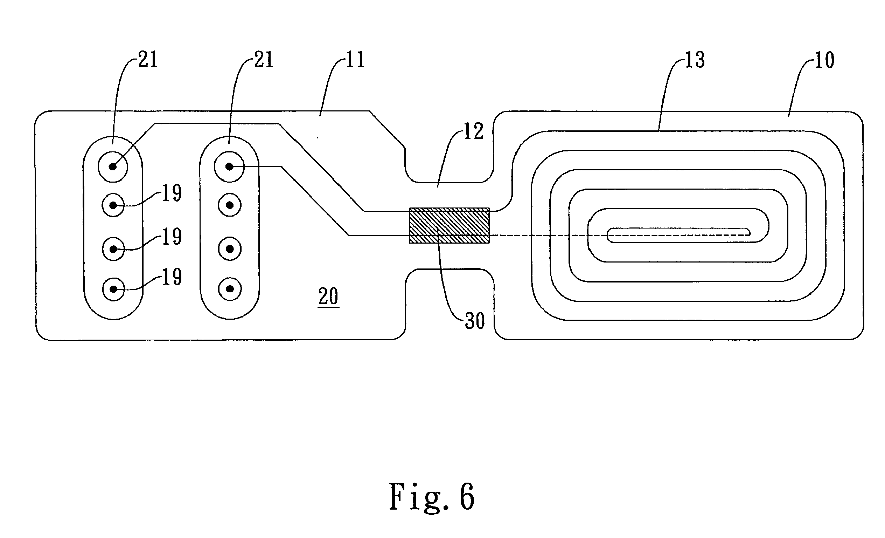

Fig. 6 is a top view of the present signal processing device. As shown in Fig. 6, the signal processing device comprises a first substrate 11 whose one side surface is provided with at least a first contact and a second contact and whose size is the same as that of a SIM card or an USIM card, wherein the first substrate 11 is connected to a second substrate 10 via a first connecting portion 12 (i.e. the bent portion) which has a predetermined length. In one embodiment of the present invention, one side surface of the first substrate 11 of the signal processing device is provided with a contact region 110. The contact region 110 comprises eight contacts (Vcc contact, RST contact, CLK contact, RFU contact, GND contact, Vpp contact, I/O contact, RFU contact) that meet ISO 7816 international standards, wherein the first and second contacts correspond to the two RFU contacts, respectively. The adhering region arranged at one side surface of the first substrate 11 is coated with an adhesive material so that the first substrate 11 can be adhered to one side surface of a SIM card or an USIM card. When the first substrate 11 is adhered to the SIM card or USIM card, the contacts of the contact region 110 are electrically connected to the corresponding eight contacts that meet ISO 7816 international standards on one surface of the SIM card or USIM card. Consequently, the SIM card or USIM card integrated with the present signal processing device can perform the NFC function.

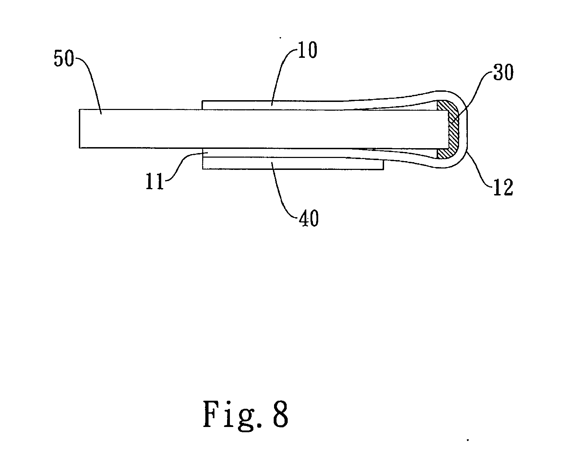

The second substrate 10 of the present signal processing device is provided with an antenna 13. The antenna 13 is a planar coil, and the traces at the two ends thereof extend through the first connecting portion 12 to electrically connect to the first and second contacts of the first substrate 11, respectively. In one embodiment of the present invention, the first substrate 11, the first connecting portion 12 and the second substrate 10 are all fabricated using the FPC technology. Referring to Fig. 8, the inwardly bent surface of the first connecting portion 12 is attached with a buffering pad 30 in order to resolve the problem that a dead fold may be formed on the first connecting portion 12 when the SIM card 40 attached with the signal processing device is to be inserted into the slot.

In one embodiment of the present invention, the buffering pad 30 is fabricated from a PORON material. Available products are as follows: SRS-40P with a thickness of 0.4 mm; SRS-48P with a thickness of 0.3 mm; SRS-70P with a thickness of 0.2 mm. Among the aforementioned three products, SRS-70P with a thickness of 0.2 mm is the preferable one.

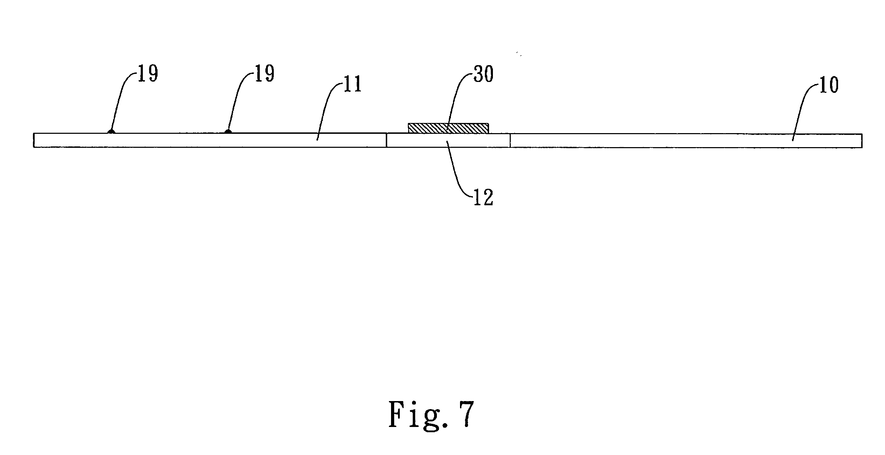

Additionally, in one embodiment of the present invention, each of the first and second contacts of the first substrate 11 has a protrusion 19 at the center thereof. Referring to Fig. 7, the protrusion 19 has a predetermined height which is sufficient to ensure that the first and second contacts are electrically connected to the corresponding contacts when the first substrate 11 is attached to one surface of a SIM card 40 or an USIM card. A SIM card will be used to demonstrate the embodiments of the present invention in the following paragraphs.

Fig. 8 is a side view showing the combination of the present signal processing device integrated with the SIM card 40 and the mobile phone battery. In one embodiment of the present invention, the SIM card slot is arranged underneath the battery 50 to conform to the interior layout of the mobile phone (not shown). After the present signal processing device is integrated with the SIM card 40, the second substrate 10 can be flipped over one side edge of the battery 50 to cover the top surface of the battery 50, and the buffering pad 30 of the first connecting portion 12 is positioned by one side edge of the battery 50 so that a dead fold will not be formed on the first connecting portion 12 when the battery compartment lid is closed.

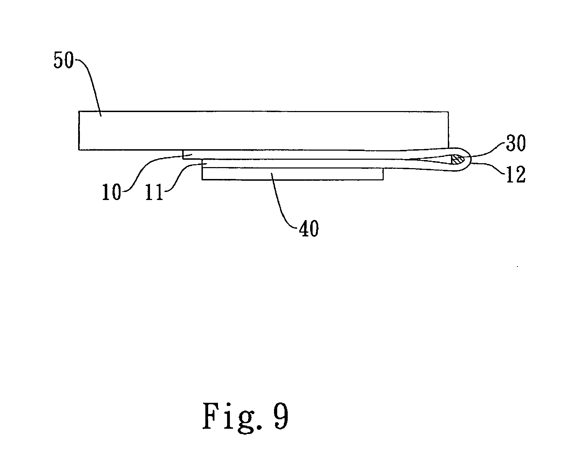

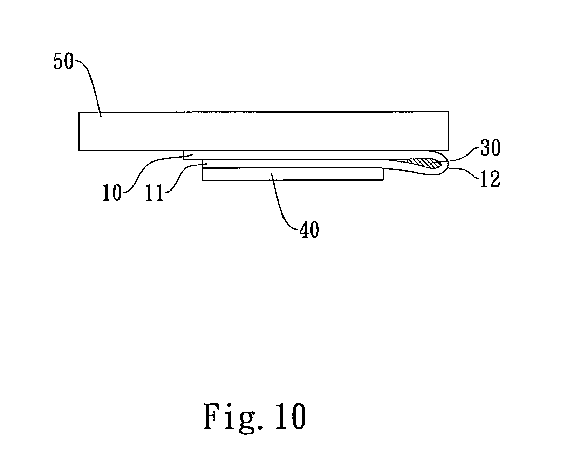

Fig. 9 is a side view showing another way of combination of the present signal processing device integrated with the SIM card 40 and the mobile phone battery. In one embodiment of the present invention, the SIM card slot is also arranged underneath the battery 50 to conform to the interior layout of the mobile phone (not shown). After the present signal processing device is integrated with the SIM card 40, the second substrate 10 can be reversely bent to cover the top surface of the first substrate 11, and the bent portion can be supported by the buffering pad 30 of the first connecting portion 12. After the SIM card 40 is inserted into the slot, the battery 50 is positioned over the second substrate 10. As the first connecting portion 12 is supported by the buffering pad 30, a dead fold can be prevented from forming on the first connecting portion 12 when the battery compartment lid is closed. Even if the battery 50 is positioned over the second substrate 10 and the bent portion of the first connecting portion 12 to conform to the interior layout of the mobile phone (see Fig. 10), the buffering pad 30 attached to the bent portion can prevent a dead fold from forming on the first connecting portion 12 when the battery compartment lid is closed.

With the detailed description of the preferred embodiments of the present invention, it will be apparent to those skilled in the art that various modifications and variations can be made to the present invention without departing from the spirit and scope of the present invention. The embodiments depicted above are not intended as limitations but rather as examples of the present invention.

## Claims

1. A signal processing device comprising:
a first substrate, one side surface thereof being provided with at least a first contact and a second contact while the other side surface thereof being provided with at least a third contact and a fourth contact, there being an electrical connection between the first and third contacts;
a second substrate, one side surface thereof being provided with at least an IC; and
a first connecting portion for connecting the first and second substrates; wherein the second and fourth contacts are electrically connected to the IC via the first connecting portion.

2. The signal processing device according to claim 1 further comprising:
a third substrate, one side surface thereof being provided with at least a fifth contact and a sixth contact while the other side surface thereof being provided with at least a seventh contact and a eighth contact, there being an electrical connection between the fifth and seventh contacts; and
a second connecting portion for connecting the third and second substrates; wherein the sixth and eighth contacts are electrically connected to the IC via the second connecting portion.

3. The signal processing device according to claim 1, wherein the IC converts signals between the second and fourth contacts.

4. The signal processing device according to claim 2, wherein the IC converts signals between the sixth and eighth contacts.

5. The signal processing device according to claim 1, wherein the first and third contacts electrically connect to electrical grounding.

6. The signal processing device according to claim 1, wherein the first and third contacts electrically connect to power source.

7. The signal processing device according to claim 1, wherein the first and second contacts are configured to electrically connect to a SIM card, and the third and fourth contacts are configured to electrically connect to a portable communication device.

8. The signal processing device according to claim 2, wherein the fifth and sixth contacts are configured to electrically connect to a SIM card, and the seventh and eighth contacts are configured to electrically connect to a portable communication device.

9. The signal processing device according to claim 1, wherein the side surface of the second substrate at which the IC is disposed is provided with two copper posts.

10. The signal processing device according to claim 9, wherein a height of the two copper posts is at least greater than that of the IC.

11. The signal processing device according to claim 9, wherein the two copper posts are electrically connected to the second or fourth contact.

12. The signal processing device according to claim 9, wherein the two copper posts are configured to electrically connect to an antenna coil.

13. The signal processing device according to claim 1, wherein one side surface of the first connecting portion is provided with a buffering pad to prevent a dead fold from forming on the first connecting portion.

14. The signal processing device according to claim 13, wherein the buffering pad is fabricated from a PORON material.

15. The signal processing device according to claim 1, wherein the side surface of the second substrate at which the IC is disposed is provided with at least a protrusion, and the height of the two copper posts is at least greater than that of the IC.

16. The signal processing device according to claim 1, wherein the first connecting portion has a length of 6-18 mm.

17. A signal processing device comprising:
a first substrate, one side surface thereof being provided with a first contact and a second contact;
a second substrate provided with an antenna coil; and
a first connecting portion for connecting the first and second substrates; wherein the first and second contacts are electrically connected to the antenna coil via the first connecting portion; and wherein one side surface of the first connecting portion is provided with a buffering pad to prevent a dead fold from forming on the bent portion.

18. The signal processing device according to claim 17, wherein the buffering pad is fabricated from a PORON material.

19. The signal processing device according to claim 17, wherein the thickness of the buffering pad is at least greater than 100 µm.

20. The signal processing device according to claim 17, wherein the first and second contacts of the first substrate are configured to electrically connect to the electrical contacts of a SIM card.
